# EUROPÄISCHE PATENTSCHRIFT

(11) **EP 3 385 125 B1**
(45) Veröffentlichungstag und Bekanntmachung des Hinweises auf die Patenterteilung: **13.10.2021**
(21) Anmeldenummer: 18160075.0
(22) Anmeldetag: 06.03.2018
(51) Int. Cl.: B60R 16/02, H01B 11/06, H05K 9/00

(54) **KRAFTFAHRZEUG**
MOTOR VEHICLE
VÉHICULE AUTOMOBILE

(30) Priorität: 06.04.2017 DE 102017205855
(43) Veröffentlichungstag der Anmeldung: 10.10.2018
(73) Patentinhaber: AUDI AG, 85045 Ingolstadt (DE)
(72) Erfinder: Rinkleff, Thomas, 85055 Ingolstadt (DE); Cenanovic, Amir, 85120 Hepberg (DE)

(56) Entgegenhaltungen:
- DE-T5-112012 006 282
- JP-A- H06 112 048
- JP-A- 2001 313 216
- US-A1- 2013 069 741
- US-A1- 2015 289 423

## Beschreibung

Die Erfindung betrifft ein Kraftfahrzeug nach Oberbegriff des Anspruchs 1.

In modernen Kraftfahrzeugen werden in zunehmendem Maße elektronische Komponenten verbaut und eingesetzt, die empfindlich auf in ihrer Umgebung herrschende Magnetfelder reagieren. Auch kommen in verschiedenen Bereichen Sensoren zur Anwendung, deren Wirkprinzip auf der Messung von Magnetfeldern, wie es beispielsweise bei Hall-Sensoren der Fall ist, beruht. Insbesondere beim Starten von Verbrennungsmaschinen über einen Anlasser oder beim Betrieb von das Kraftfahrzeug antreibenden Elektromotoren fließen Ströme mit großer Stromstärke, welche entsprechend starke Magnetfelder erzeugen. Im Stand der Technik werden verschiedene Lösungen vorgeschlagen, wie im Allgemeinen von bestromten Leitungen erzeugte Magnetfelder gedämpft oder abgeschwächt werden können.

So zeigt die Druckschrift JP 2003061268 A ein kontaktloses Übertragungssystem für die Übertragungen von elektrischer Energie von einer eine Hin- und Rückleitung aufweisenden Leitungsanordnung zu einem Fahrzeug. Durch besondere Gestaltungen des Stromabnehmers des Fahrzeugs wird es ermöglicht, die stromführende Zuleitung und die stromführende Rückleitung in einem verringerten Abstand zueinander anzuordnen, wodurch das von den Leitungen erzeugte Magnetfeld in der Umgebung verringert wird.

Druckschrift EP 2 138 859 A1 zeigt einen Heizer mit stromführenden Leitungen, welche derart verlegt und induktiv gekoppelt werden, dass sich die Magnetfelder der einzelnen stromführenden Leitungen in entgegengesetzte Richtungen ausbreiten und sich in Summe so gegenseitig verringern.

Druckschrift DE 296 13 339 U1 offenbart ein elektrisch betriebenes Heizelement, bei dem die Stromzufuhr auf mindestens zwei sich erwärmende Stromleiter aufgeteilt ist, so dass die Stromleiter paarweise im Heizelement geführt werden können. Durch diese paarweise Anordnung der stromführenden Stromleiter werden die sich aufbauenden Magnetfelder in der Umgebung des Heizelements abgeschwächt.

Diese im Stand der Technik beschriebenen Lösungen haben gemein, dass wenigstens zwei stromführende Leitungen so zueinander angeordnet werden, dass durch entgegengesetzt fließende Ströme die entstehenden Magnetfelder in Summe abgeschwächt werden. Für den Einsatz in einem Kraftfahrzeug ist eine solche Lösung nicht immer praktikabel, da eine solche Lösung mit einem erheblichen Aufwand in der Leitungsführung innerhalb des Kraftfahrzeugs einhergeht.

Aus der gattungsbildenden DE 11 2012 006 282 T5 ist ein Kabelstrang bekannt, welcher drei Netzkabel zur Leitung von symmetrischer Drei-Phasen-Wechselstrom-Elektrizität umfasst. Die drei Netzkabel werden von drei leitfähigen elektromagnetischen Abschirmelementen umschlossen, welche über ein zwischenliegendes Kurzschlusselement bereichsweise verbunden sind.

In US 2015/0289423 A1 wird ein Kabelbaum beschrieben, welcher drei elektrische Leiter sowie eine geflochtene Abschirmung umfasst. Die drei elektrischen Leiter sind bereichsweise von einem Mantelwellenfilter umgeben, wobei der Mantelwellenfilter aufgrund der geflochtenen Abschirmung axial entlang der elektrischen Leiter verschoben werden kann.

Aus US 2013/069741 A1 ist eine Vorrichtung zum Reduzieren von elektromagnetischen Störungen in einer Leitung 1 bekannt. Diese Vorrichtung umfasst eine Mehrzahl von Magneten, welche ringförmig ausgebildet sind, und durch welche die Leitung sowie zwei Windungen einer Leiterschleife geführt sind. Durch die Magnetanordnung wird eine induktive Kopplung zwischen der Leitung und der Leiterschleife erzeugt, sodass auf der Leitung auftretende elektromagnetische Störungen reduziert werden können.

Der Erfindung liegt daher die Aufgabe zugrunde, ein Kraftfahrzeug anzugeben, welches eine verbesserte Abdämpfung von Magnetfeldern aufweist.

Zur Lösung dieser Aufgabe ist erfindungsgemäß ein Kraftfahrzeug nach Anspruch 1 vorgesehen.

Der Vorteil der erfindungsgemäßen Lösung besteht darin, dass die Dämpfungsleitungsanordnung selbst keinen Strom führt, sondern in ihr durch das Magnetfeld, welches von dem in der Nutzstromleitung fließenden Nutzstrom erzeugt wird, ein Stromfluss induziert wird. Durch diesen induzierten Stromfluss wird ein dem Magnetfeld des Nutzstroms entgegengesetztes Magnetfeld erzeugt. Es handelt sich bei der Dämpfungsleitungsanordnung folglich um eine Anordnung von einem oder mehreren, passiven Leitern, die nicht an eine Stromquelle angeschlossen sind. Die Dämpfungsleitungsanordnung wird weiterhin derart an die Nutzstromleitung induktiv gekoppelt, dass das durch den Nutzstrom erzeugte Magnetfeld in einem von der Nutzstromleitung und der Dämpfungsleitungsanordnung beabstandeten Schutzbereich gedämpft wird. Diese Dämpfung entsteht durch Überlagerung mit dem Magnetfeld, welches durch den in der Dämpfungsleitungsanordnung induzierten Stromfluss erzeugt wird. Der Erfindung liegt die Erkenntnis zu Grunde, dass es in vielen Fällen ausreichend ist, lokal - im Schutzbereich - zu dämpfen, so dass der zu treibende Aufwand reduziert werden kann und insbesondere eine passive, speziell auf die Dämpfung im Schutzbereich ausgelegte Maßnahme hinreichend ist. In dem Schutzbereich wird folglich ein Betrag der dort vorherrschenden magnetischen Feldstärke signifikant, z. B. um wenigstens 50 %, gedämpft, ohne dass dazu eine aktiv bestromte, zusätzliche Leitung eingesetzt werden muss. Durch Auslegung der Dämpfungsleitungsanordnung, vor allem über die Stärke der induktiven Kopplung zwischen der Nutzstromleitung und der Dämpfungsleitungsanordnung, kann gezielt im Schutzbereich eine Dämpfung des Magnetfeldes erreicht werden.

Die erfindungsgemäße Lösung ermöglicht es also lokal in besonders schutzbedürftigen Bereichen eine erhebliche Verringerung der magnetischen Feldstärke, also gemeinhin eine Dämpfung des Magnetfeldes, vorzunehmen, ohne dass dabei aktiv bestromte Leitungen oder magnetische Abschirmungen eingesetzt werden.

Da die Lage von Schutzbereich und Nutzstromleitung bekannt ist, kann abhängig von der zu erzielenden Dämpfung des Magnetfeldes im Schutzbereich die benötigte Stärke der induktiven Kopplung durch Berechnung und/oder Simulation auf Grundlage der bekannten physikalischen Gesetze zur Induktion und Magnetismus im Vorfeld bestimmt werden. Gemäß der dadurch erhaltenen Ergebnisse werden die induktive Kopplung zwischen Nutzstromleitung und Dämpfungsleitungsanordnung und/oder die konkrete geometrische und/oder schaltungstechnische Ausgestaltung der Dämpfungsleistungsanordnung anschließend technisch umgesetzt. Die induktive Kopplung kann z. B. durch den Abstand zwischen Nutzstromleitung und Dämpfungsleitungsanordnung beeinflusst werden.

Der Schutzbereich, in dem eine Dämpfung des Magnetfelds erzielt wird, kann dabei sowohl innerhalb des Kraftfahrzeugs als auch außerhalb des Kraftfahrzeugs liegen und abhängig vom Anwendungsfall eine größere oder kleinere Ausdehnung haben. Bevorzugt wird eine solche Dämpfungsleitungsanordnung an Nutzstromleitungen vorgesehen, die dazu ausgebildet sind, zumindest zeitweise einen Nutzstrom mit einer Stromstärke von größer als 50 Ampere zu führen, da derart starke Ströme mit der Bildung von starken Magnetfeldern einhergehen, deren Stärke im Schutzbereich zu dämpfen ist.

Es ist auch möglich, die induktive Kopplung und die Anordnung der Dämpfungsleitungsanordnung so auszulegen, dass Magnetfelder, welche von einer den Nutzstrom überlagernden Störung erzeugt werden, im Schutzbereich gedämpft werden. Dies trifft beispielsweise auch auf Störungen zu, die auf zwei oder mehr Nutzstromleitungen als Gleichtaktstörungen (common mode-Störung) oder als Gegentaktstörungen (differential mode-Störung) auftreten. Dies können insbesondere Magnetfelder sein, welche in einem bestimmten Frequenzbereich auftreten. Ausgelöst werden können solche Störungen beispielsweise durch elektrische Maschinen oder durch Leistungselektronik wie beispielsweise Wechselrichter.

Weiterhin ist es möglich, die Dämpfungsleitungsanordnung so auszulegen, dass auch ein Magnetfeld, welches durch einen vom Nutzstrom hervorgerufenen Leckstrom erzeugt wird, im Schutzbereich gedämpft wird. Bei diesen Leckströmen kann es sich z. B. um Ströme handeln, die parasitär über Gehäuse von elektrischen Maschinen oder elektrischen Schaltungsanordnungen und/oder über die Karosserie des Kraftfahrzeugs abfließen.

Erfindungsgemäß ist für die Dämpfungsleitungsanordnung vorgesehen, dass sie wenigstens eine Dämpfungsleitung umfasst. Die Dämpfungsleitung und eine gegebenenfalls zusätzlich vorhandene Dämpfungsleiterschleife können beispielsweise als Kupferkabel realisiert werden und gegebenenfalls eine äußere Isolierung aufweisen. Abhängig von der Ausführung der Dämpfungsleitungsanordnung können Magnetfelder, welche auf unterschiedlichen Störungsquellen beruhen, gedämpft werden. Zum Beispiel können bevorzugt Dämpfungsleitungen eingesetzt werden, um common mode-Störungen abzudämpfen sowie entsprechend Dämpfungsleiterschleifen bei differential mode-Störungen. Für die Dämpfungsleitungsanordnung kann weiterhin vorgesehen sein, dass sie mehrere Dämpfungsleitungen und/oder Dämpfungsleiterschleifen aufweist, welche als Bündel zusammengefasst sind, wobei bei einem solchen Bündel von Dämpfungsleitungen bzw. Dämpfungsleiterschleifen bevorzugt Leiter mit einem dünneren Querschnitt zum Einsatz kommen als beim Einsatz einzelner Dämpfungsleitungen oder Dämpfungsleiterschleifen. Alternativ dazu ist es möglich, dass auch Dämpfungsleiterschleifen verwendet werden, welche mehrere Wicklungen umfassen.

Erfindungsgemäß ist in einer ersten Alternative vorgesehen, dass das Kraftfahrzeug eine Karosserie aufweist und dass die Dämpfungsleitung an beiden Enden mit der Karosserie verbunden ist. Die Dämpfungsleitung ist in diesem Fall über die Karosserie an beiden Enden geerdet. Eine solche Anordnung kann bevorzugt zur Dämpfung von common mode-Störungen verwendet werden.

Alternativ dazu ist es in einer zweiten Alternative erfindungsgemäß vorgesehen, dass das Kraftfahrzeug eine Leistungselektronik aufweist, der elektrische Verbraucher ein Elektromotor ist und die Dämpfungsleitung mit einem Gehäuse der Leistungselektronik und einem Gehäuse des Elektromotors verbunden ist. Beispielsweise kann die Dämpfungsleitung zwischen einem Antriebsmotor und einer den Antriebsmotor speisenden Leistungselektronik, wie beispielsweise einem Wechselrichter, verbunden werden, wobei der Wechselrichter die Gleichspannung eines Batteriespeichers in Wechselspannung zum Betrieb eines als Synchronmotor oder Asynchronmotor ausgeführten Antriebsmotor umwandelt. Es ist in diesem Fall auch möglich, dass die Dämpfungsleitung oder eine weitere Dämpfungsleitung mit dem Batteriespeicher und der Leistungselektronik verbunden angeordnet ist. Eine verstärkte induktive Kopplung kann außerhalb eines Gehäuses von Antriebsmotor oder Leistungselektronik erfolgen oder innerhalb eines solchen.

Für die Dämpfungsleitungsanordnung ist erfindungsgemäß vorgesehen, dass die Dämpfungsleitung zumindest abschnittsweise parallel zu der Nutzstromleitung angeordnet ist. Durch eine solche Anordnung wird eine räumlich gleichförmigere Dämpfung des Magnetfelds im Schutzbereich ermöglicht. Die Parallelität zwischen der Dämpfungsleitungsanordnung und der Nutzstromleitung kann dabei sowohl zwischen geraden Abschnitten als auch zwischen gekrümmten Abschnitten durch eine äquidistante Anordnung der Dämpfungsleitungsanordnung bzw. der einzelnen Dämpfungsleitungen und/oder Dämpfungsleiterschleifen erfolgen, wodurch diese im konstanten Abstand zumindest abschnittsweise dem Verlauf der Nutzstromleitung folgen.

Um eine Frequenzanpassung der Magnetfelddämpfung zu erzielen, kann erfindungsgemäß vorgesehen sein, dass die Dämpfungsleitungsanordnung wenigstens ein elektrisches Filter umfasst. Bei einem solchen Filter kann es sich beispielsweise um wenigstens einen Kondensator oder um einen aus einem oder mehreren LC-Gliedern bestehenden Bandpass handeln, welcher so abgestimmt ist, dass eine Magnetfelddämpfung im gewünschten Frequenzbereich erfolgt. Magnetfelder mit Frequenzen außerhalb des gewünschten Frequenzbereichs werden dadurch weniger stark gedämpft als Magnetfelder, deren Frequenz im gewünschten Frequenzbereich liegt. Damit können beispielsweise gezielt Magnetfelder gedämpft werden, deren Frequenzen beispielsweise im kHz-Bereich liegen. Generell ist es möglich, durch Anpassung des elektrischen Filters die Magnetfelddämpfung an den Frequenzbereich der beispielsweise durch auftretende common mode- oder differential mode-Störungen erzeugten Magnetfelds beliebig anzupassen.

Für die induktive Kopplung zwischen Nutzstromleitung und Dämpfungsleitungsanordnung ist erfindungsgemäß vorgesehen, dass sie durch wenigstens ein die Nutzleitung und die Dämpfungsleitungsanordnung umgreifendes Kopplungsbauteil verstärkt ist. Die Nutzleitung und die Dämpfungsleitungsanordnung sind somit nicht allein über ihre in einem gewissen Abstand zueinander erfolgte Anordnung induktiv gekoppelt, sondern weisen durch das Kopplungsbauteil eine verstärkte induktive Kopplung auf. Das Kopplungsbauteil kann dabei so ausgeführt sein, dass es zur Führung eines magnetischen Flusses geeignet ist. Das Kopplungsbauteil kann dabei insbesondere die Nutzleitung sowie alle Dämpfungsleitungen und/oder Dämpfungsleiterschleifen der Dämpfungsleitungsanordnung umgreifen. Durch eine Wahl der Eigenschaften des Kopplungsbauteils sowie über die Anzahl der verwendeten Kopplungsbauteile kann die Stärke der induktiven Kopplung zwischen Nutzstromleitung und Dämpfungsleitungsanordnung beeinflusst werden.

Erfindungsgemäß kann das Kopplungsbauteil ein Magnetring sein. Dabei werden sowohl die Dämpfungsleitungsanordnungen als auch die Nutzleitung durch das Loch des Ringes geführt und durch den sie umgreifenden Magnetring verstärkt induktiv gekoppelt. Der Durchmesser und die Dicke des Ringes können dabei abhängig von der durch Berechnung und/oder Simulation bestimmten, für die Dämpfung im Schutzbereich benötigten Stärke der induktiven Kopplung gewählt werden.

Weiterhin ist erfindungsgemäß vorgesehen, dass der Magnetring aus Ferrit oder einem nanokristallinen Werkstoff besteht. Die Verwendung von Ferrit oder einem nanokristallinen, magnetischen Werkstoff bringt hierbei den Vorteil, dass diese Materialien aufgrund ihrer Eigenschaften durch die Führung des magnetischen Flusses eine besonders starke induktive Kopplung zwischen Nutzstromleitung und Dämpfungsleitungsanordnung ermöglichen.

Für den Schutzbereich kann erfindungsgemäß vorgesehen sein, dass er ein Personenaufenthaltsbereich ist und/oder den Bereich einer elektrischen Schaltungsanordnung und/oder einer Sensoranordnung, insbesondere eines Hall-Sensors, einschließt. Ein Personenaufenthaltsbereich kann dabei sowohl innerhalb des Kraftfahrzeugs als auch außerhalb des Kraftfahrzeugs liegen. Bei der elektrischen Schaltungsanordnung und/oder der Sensoranordnung handelt es sich bevorzugt um Komponenten innerhalb des Fahrzeugs. Durch die erfindungsgemäß vorgesehene Dämpfungsanordnung werden in diesem Schutzbereich auftretende Magnetfelder gedämpft, so dass Personenaufenthaltsbereiche und/oder Bereiche mit Elektronik oder magnetfeldsensibler Sensorik vor dem Auftreten von hohen Magnetfeldern geschützt werden. Die Schutzbereiche können je nach Anwendungsfall, bzw. je nach Größe des zu schützenden Bereiches oder des zu schützenden Objektes, eine unterschiedliche räumliche Ausdehnung aufweisen.

In einer weiteren Ausgestaltung der Erfindung ist vorgesehen, dass der elektrische Verbraucher ein Anlasser oder ein Antriebsmotor des Kraftfahrzeugs ist. Der Nutzstrom kann demzufolge ein Anlasserstrom sein, der beim Starten eines Verbrennungsmotors fließt oder ein Strom, der beim Anfahren oder beim andauernden Betrieb eines zum Fahrzeugvortrieb verwendeten Antriebsmotors fließt. Der Nutzstrom kann somit ein Gleichstrom, ein Wechselstrom oder eine Überlagerung von beidem sein. Bei einem als Gleichstrom fließenden Nutzstrom dämpft die Dämpfungsleitungsanordnung insbesondere Magnetfelder, die durch die Änderung des Stromflusses beim Anschalten oder Abschalten des Gleichstroms entstehen, wohingegen bei einem als Wechselstrom fließenden Nutzstrom sowie bei einer Überlagerung von Gleichstrom und Wechselstrom die durch den Wechselstrom erzeugten Magnetfelder gedämpft werden. Eine Überlagerung von Gleichstrom und Wechselstrom kann insbesondere bei einem als Gleichstrom fließenden Nutzstrom vorliegen, welcher durch eine in einem gewissen Frequenzbereich auftretende Störung überlagert wird. Weitere Vorteile und Einzelheiten der Erfindung ergeben sich aus den im Folgenden beschriebenen Ausführungsbeispielen sowie anhand der Zeichnungen. Dabei zeigen:
- Fig. 1: eine Prinzipdarstellung eines erfindungsgemäßen Kraftfahrzeugs,
- Fig. 2: eine perspektivische Detailansicht einer verstärkten induktiven Kopplung zwischen Nutzstromleitung und Dämpfungsleitungsanordnung,
- Fig. 3: eine Prinzipdarstellung eines weiteren Ausführungsbeispiels eines erfindungsgemäßen Kraftfahrzeugs, sowie
- Fig. 4 bis 9: weitere Ausführungsbeispiele von induktiv an verschiedene Nutzstromleitungen gekoppelten Dämpfungsleitungsanordnungen, wobei die Figuren 6 und 8 erfindungsgemäße Ausführungsbeispiele und die Figuren 4, 5, 7 und 9 nicht erfindungsgemäße Ausführungsbeispiele zeigen.

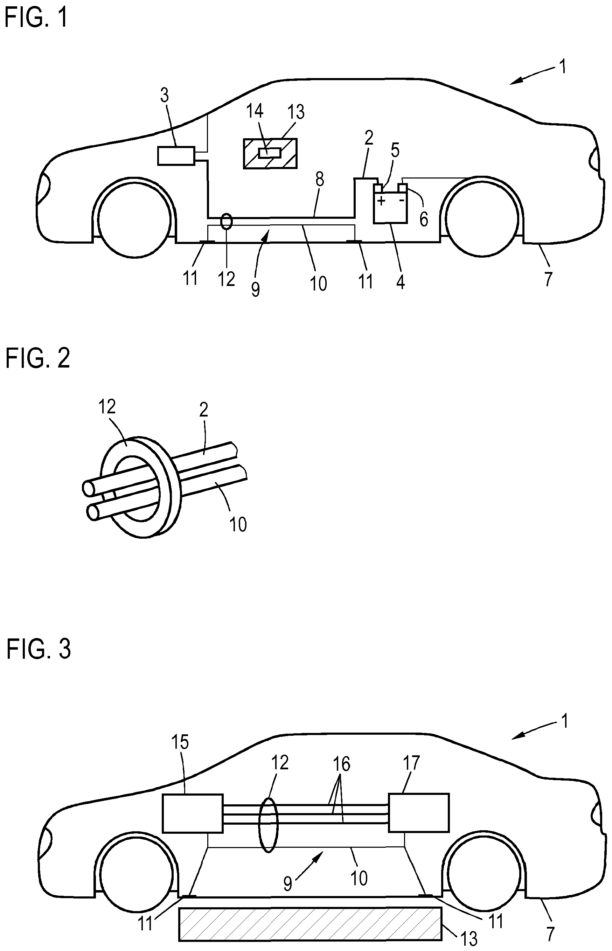

Fig. 1 zeigt eine Prinzipdarstellung eines erfindungsgemäßen Kraftfahrzeugs 1. Das Kraftfahrzeug 1 umfasst eine Nutzstromleitung 2, welche einen Anlasser 3 als elektrischen Verbraucher mit einer Batterie 4 des Kraftfahrzeugs 1 verbindet. Der Anlasser 3 ist hierbei an den Pluspol 5 der Batterie 4 angeschlossen, wohingegen der Minuspol 6 der Batterie 4 an die Karosserie 7 angeschlossen ist. Einem Abschnitt 8 der Nutzstromleitung 2 ist eine Dämpfungsleitungsanordnung 9 abschnittsweise parallel angeordnet. Die Dämpfungsleitungsanordnung 9 umfasst dabei eine passive Dämpfungsleitung 10, deren Enden 11 mit der Karosserie 7 verbunden sind. Die induktive Kopplung zwischen Nutzleitung 8 und Dämpfungsleitung 10 ist durch einen Magnetring 12, welcher sowohl die Nutzstromleitung 2 als auch die Dämpfungsleitung 10 umgreift, verstärkt. Beim Starten eines Verbrennungsmotors (nicht gezeigt) fließt durch die Nutzstromleitung 2 ein Nutzstrom von der Batterie 4 zum Anlasser 3, wobei der Nutzstrom ein Magnetfeld erzeugt. Gleichzeitig wird beim Startvorgang durch das Magnetfeld des Nutzstroms in der Dämpfungsleitung 10 ein Stromfluss induziert, welcher seinerseits ein dem vom Nutzstrom erzeugten Magnetfeld entgegengesetzt gerichtetes Magnetfeld erzeugt, wodurch das insgesamt in einem Schutzbereich 13 auftretende Magnetfeld gedämpft wird. Der Schutzbereich 13 umfasst in diesem Beispiel eine als Hall-Sonde ausgeführte Sensoranordnung 14. Insbesondere beim Startvorgang und beim Abschalten des Nutzstromflusses durch die Nutzstromleitung 2 werden durch die induktive Kopplung der Nutzstromleitung 2 mit der Dämpfungsleitung 10 auftretende Magnetfelder im Schutzbereich 13 abgedämpft, wodurch die Sensoranordnung 14 vor Beschädigungen oder Fehlfunktion geschützt ist. In der Dämpfungsleitung 10 fließt nur zu dem Zeitpunkt ein Strom, in dem das vom Nutzstrom erzeugte Magnetfeld in der Dämpfungsleitung 10 einen Stromfluss induziert. Der Betrag des induzierten Stromflusses und damit der Betrag der Magnetfelddämpfung hängt hierbei von der Stärke der induktiven Kopplung zwischen Nutzstromleitung 2 und Dämpfungsleitungsanordnung 9 ab. Abhängig von der Lage des Schutzbereichs 13 kann die benötigte Stärke der induktiven Kopplung durch Berechnung und/oder Simulation bestimmt werden.

Fig. 2 zeigt eine Detailansicht der Nutzstromleitung 2 und der Dämpfungsleitung 10, welche über den Magnetring 12 verstärkt induktiv gekoppelt sind. Die Nutzstromleitung 2 und die Dämpfungsleitung 10 werden hierbei durch die Öffnung des Magnetrings 12 geführt. Der Magnetring 12 kann dabei beispielsweise aus Ferrit oder einem nanokristallinen Magnetwerkstoff bestehen. In dem Fall, dass die Dämpfungsleitungsanordnung 9 mehr als eine Dämpfungsleitung 10 bzw. mehr als eine Dämpfungsleiterschleife umfasst, können all diese zusätzlich zur Nutzstromleitung 2 durch die Öffnung des Magnetrings 12 geführt werden. Ebenso können mehrere Nutzstromleitungen 2 durch die Öffnung des Magnetrings geführt werden.

Fig. 3 zeigt ein weiteres Ausführungsbeispiel eines erfindungsgemäßen Kraftfahrzeugs 1. In diesem Beispiel ist ein Elektromotor 15 über drei Nutzstromleitungen 16 mit einer als Pulswechselrichter ausgeführten Leistungselektronik 17 verbunden. Die Nutzstromleitungen 16 dienen hierbei zur Übertragung eines dreiphasigen Nutzstroms zur Bestromung des Antriebsmotors 15. Das Kraftfahrzeug 1 weist ferner eine Dämpfungsleitungsanordnung 9 auf, welche eine Dämpfungsleitung 10 umfasst, die an ihren Enden 11 mit der Karosserie 7 des Kraftfahrzeugs 1 verbunden ist. Die Dämpfungsleitung 10 ist über den Magnetring 12 mit den drei Nutzstromleitungen 16 verstärkt induktiv gekoppelt. Dadurch werden Magnetfelder, die von auf den Nutzstromleitungen 16 auftretenden common mode-Störungen erzeugt werden, in einem Schutzbereich 13 abgedämpft. Der Schutzbereich 13 liegt in diesem Beispiel außerhalb des Kraftfahrzeugs 1. Ferner werden durch die Dämpfungsleitungsanordnung 9 Magnetfelder gedämpft, die durch einen von der common mode-Störung hervorgerufenen parasitären Leckstrom erzeugt werden, welcher zwischen den Gehäusen der Leistungselektronik 17 und des Antriebsmotors 15 über die Karosserie 7 des Fahrzeugs fließt.

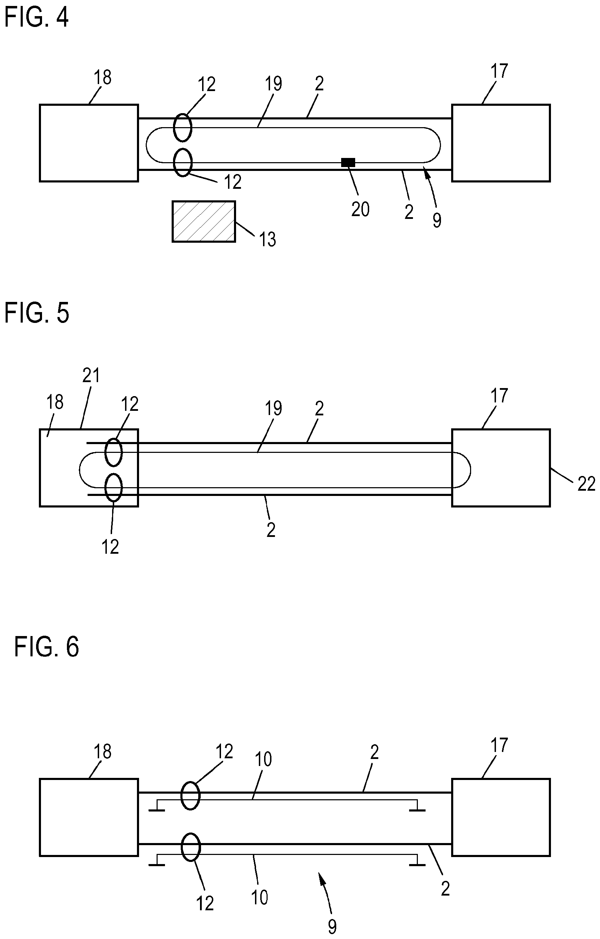

In den Fig. 4 bis 9 werden weitere Ausführungsbeispiele von erfindungsgemäß an verschiedenen Nutzstromleitungen 2, 16 angeordneten Dämpfungsleitungsanordnungen 9 gezeigt. Hierbei sind die Nutzstromleitungen 2, 16 stets durch einen dicken Strich dargestellt, wohingegen die Dämpfungsleitungen 10 bzw. die Dämpfungsleiterschleifen 19, 25 durch einen dünnen Strich dargestellt sind. Dies dient allein der besseren Unterscheidbarkeit, da es für die beispielsweise als Kupferkabel realisierten Nutzstromleitungen 2, 16, Dämpfungsleitungen 10, und Dämpfungsleiterschleifen 19, 25 insbesondere vorgesehen sein kann, dass sie einen gleichen Durchmesser aufweisen.

Fig. 4 zeigt eine Batterie 18, welche über zwei Nutzstromleitungen 2 mit einer Leistungselektronik 17 verbunden ist. Abschnittsweise parallel zu den Nutzstromleitungen 2 ist eine Dämpfungsleiterschleife 19 angeordnet, welche über die beiden Magnetringe 12 mit den beiden Nutzstromleitungen 2 verstärkt induktiv gekoppelt ist. Eine solche Anordnung ermöglicht es insbesondere, Magnetfelder, welche von einer differential mode-Störung erzeugt werden, die den als Gelichtakt oder Gegentakt fließenden Nutzstrom in den Nutzstromleitungen 2 überlagert, im Schutzbereich 13 zu dämpfen. Abhängig von der Lage des Schutzbereichs 13 wird die Stärke der induktiven Kopplung zwischen Nutzstromleitung 2 und Dämpfungsleitungsanordnung 9 ausgelegt. Die Dämpfungsleitungsanordnung 9, welche neben der Dämpfungsleiterschleife 19 ein mit der Dämpfungsleiterschleife 19 verbundenes elektrisches Filter 20 aufweist, kann durch die Ausgestaltung des beispielsweise als Bandpass ausgeführten Filters 20 auf den Frequenzbereich der differential mode-Störung angepasst werden. Dadurch wird ein gezieltes Abdämpfen von in einem gewissen Frequenzbereich auftretenden Magnetfeldern ermöglicht. Der Einsatz eines solchen Filters 20 ist auch bei den in den folgenden Figuren gezeigten Ausführungsbeispielen möglich. Auch ist eine Ausführung wie in Fig. 5 gezeigt möglich, bei der die Dämpfungsleiterschleife 19 innerhalb des Gehäuses 21 der Batterie 18 geführt wird und dort über die Magnetringe 12 an die Nutzstromleitungen 2 gekoppelt wird, wobei zusätzlich das andere Ende der Schleife 19 in das Gehäuse 22 der Leistungselektronik 17 geführt ist.

In Fig. 6 ist eine entsprechende Anordnung von Leistungselektronik 17 und Batterie 18 gezeigt, bei der die Dämpfungsleitungsanordnung 9 zwei Dämpfungsleitungen 10 umfasst, die jeweils parallel zu einer der beiden Nutzstromleitungen 2 angeordnet sind. Jede Dämpfungsleitung 10 ist an die ihr benachbarte Nutzstromleitung 2 über einen Magnetring 12 verstärkt induktiv gekoppelt. Eine solche Anordnung kann bevorzugt zum Abdämpfen von Magnetfeldern verwendet werden, die durch auf den Nutzstromleitungen 2 auftretende common mode-Störungen erzeugt werden.

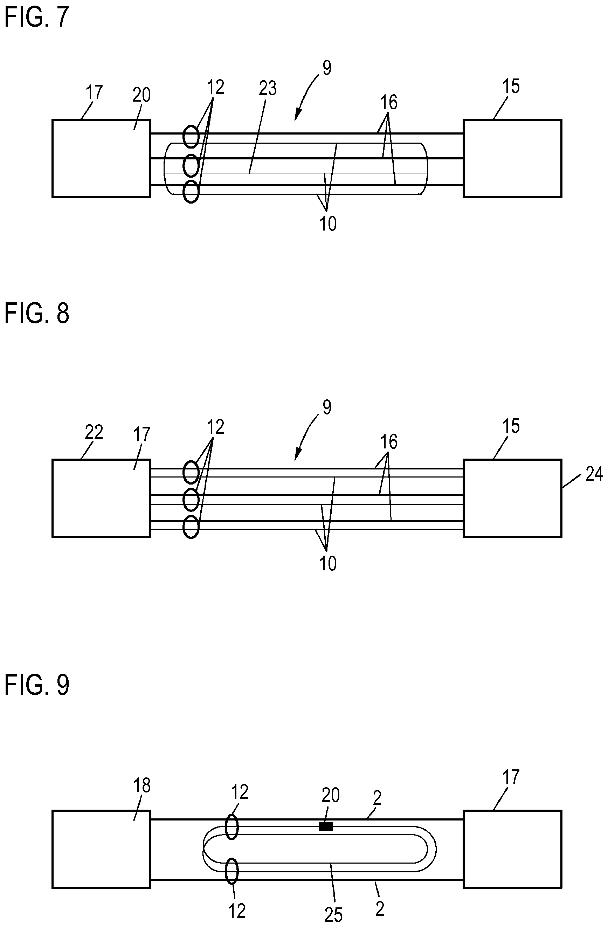

Fig. 7 zeigt ein Ausführungsbeispiel, bei der die Leistungselektronik 17 über drei Nutzstromleitungen 16 mit dem Elektromotor 15 verbunden ist. Die Dämpfungsleitungsanordnung 9 weist hierbei drei sternförmig zu einer Doppelschleife 23 verbundene Dämpfungsleitungen 10 auf. Jede der sternförmig verbundenen Dämpfungsleitungen 10 ist dabei über je einen Magnetring 12 an eine der Nutzstromleitungen 16 verstärkt induktiv gekoppelt. Durch eine solche Anordnung können Magnetfelder abgedämpft werden, welche durch eine differential mode-Störung hervorgerufen werden, die den dreiphasig in den Nutzstromleitungen 16 fließenden Nutzstrom überlagert. Eine alternative Ausführungsform dazu ist in Fig. 8 dargestellt, bei der die drei Dämpfungsleitungen 10 jeweils mit dem Gehäuse 22 der Leistungselektronik 17 sowie mit dem Gehäuse 24 des Elektromotors 15 verbunden sind. Durch eine solche Anordnung kann sowohl eine Dämpfung von Magnetfeldern erfolgen, die durch eine common mode-Störung als Überlagerung des dreiphasigen Nutzstroms erzeugt werden als auch eine Dämpfung von Magnetfeldern, die durch differential mode-Störungen auf den Nutzstromleitungen 16 erzeugt werden.

Fig. 9 zeigt ein Ausführungsbeispiel, bei dem Leistungselektronik 17 über zwei Nutzstromleitungen 2 mit der Batterie 18 verbunden ist, und die Dämpfungsleitungsanordnung 9 eine mehrere Wicklungen umfassende Dämpfungsleiterschleife 25 sowie ein mit der Dämpfungsleiterschleife 25 verbundenes elektrisches Filter 20 umfasst. Die Dämpferleiterschleife 25 verläuft dabei abschnittsweise parallel zu den Nutzstromleitungen 2 und ist über die Magnetringe 12, welche sowohl die Nutzstromleitung 2 als auch alle Wicklungen der Dämpfungsleiterschleife 25 umfassen, verstärkt induktiv mit den Nutzstromleitungen 2 gekoppelt. Die mehrere Wicklungen umfassende Dämpfungsleiterschleife 25 kann beliebig viele Wicklungen umfassen und als gewickelte Leitung, beispielsweise als gewickeltes Kupferkabel, ausgeführt sein, wobei die Enden der gewickelten Leitung zu einer Schleife verbunden sind. Eine solche Ausführungsform bietet den Vorteil, dass die Dämpfungsleiterschleife 25 einen geringeren Querschnitt aufweisen kann, da der Strom, welcher in der Dämpfungsleiterschleife 25 induziert wird, um einen Faktor entsprechend der Anzahl der Wicklungen der Dämpferleiterschleife 25 geringer ist. Ein solches Verwenden einer mehrerer Wicklungen umfassenden Dämpfungsleiterschleife 25 oder entsprechend mehrerer Dämpfungsleitungen 10 kann alternativ auch bei den vorangehenden Ausführungsbeispielen erfolgen.

## Patentansprüche

1. Kraftfahrzeug (1) umfassend wenigstens eine bestrombare Nutzstromleitung (2, 16), welche wenigstens zeitweise einen Nutzstrom zum Betrieb wenigstens eines elektrischen Verbrauchers führt, wobei wenigstens eine Dämpfungsleitungsanordnung (9) über eine induktive Kopplung derart mit der bestrombaren Nutzstromleitung (2, 16) gekoppelt ist, dass in einem von der Nutzstromleitung (2, 16) und der Dämpfungsleitungsanordnung (9) beabstandeten Schutzbereich (13) ein durch den Nutzstrom und/oder eine den Nutzstrom überlagernde Störung und/oder einen durch den Nutzstrom hervorgerufenen Leckstrom erzeugtes Magnetfeld durch in der Dämpfungsleitungsanordnung (9) induzierten Stromfluss gedämpft wird,
**dadurch gekennzeichnet,**
**dass** die Dämpfungsleitungsanordnung (9) wenigstens eine Dämpfungsleitung (10) umfasst, wobei die wenigstens eine Dämpfungsleitung (10) zumindest abschnittsweise parallel zu der Nutzstromleitung (2, 16) angeordnet ist und die induktive Kopplung durch wenigstens ein die Nutzstromleitung (2, 16) und die wenigstens eine Dämpfungsleitung (10) umgreifendes Kopplungsbauteil verstärkt ist, wobei das Kraftfahrzeug (1) eine Karosserie (7) aufweist und die Dämpfungsleitung (10) an beiden Enden (11) mit der Karosserie (7) verbunden ist, oder wobei das Kraftfahrzeug (1) eine Leistungselektronik (17) aufweist, der elektrische Verbraucher ein Elektromotor (15) ist und die Dämpfungsleitung (10) mit einem Gehäuse (22) der Leistungselektronik (17) und einem Gehäuse (24) des Elektromotors verbunden ist.

2. Kraftfahrzeug (1) nach Anspruch 1,
**dadurch gekennzeichnet,**
**dass** die Dämpfungsleitungsanordnung (9) wenigstens ein elektrisches Filter (20) umfasst.

3. Kraftfahrzeug (1) nach Anspruch 1 oder 2,
**dadurch gekennzeichnet,**
**dass** das Kopplungsbauteil ein Magnetring (12) ist.

4. Kraftfahrzeug (1) nach Anspruch 3,
**dadurch gekennzeichnet,**
**dass** der Magnetring (12) aus Ferrit oder einem nanokristallinen Werkstoff besteht.

5. Kraftfahrzeug (1) nach einem der vorangehenden Ansprüche,
**dadurch gekennzeichnet,**
**dass** der Schutzbereich (13) ein Personenaufenthaltsbereich ist und/oder den Bereich einer elektrischen Schaltungsanordnung und/oder einer Sensoranordnung, insbesondere einer Hall-Sonde (14), einschließt.

6. Kraftfahrzeug (1) nach einem der vorangehenden Ansprüche,
**dadurch gekennzeichnet,**
**dass** der elektrische Verbraucher ein Anlasser (3) oder ein Antriebsmotor (15) des Kraftfahrzeugs ist.

## Claims

1. Motor vehicle (1) comprising at least one energisable active current line (2, 16) which at least at times carries an active current for operating at least one electrical load, at least one attenuation line arrangement (9) being coupled to the energisable active current line (2, 16) by means of inductive coupling in such a way that, in a protection area (13) that is spaced from the active current line (2, 16) and the attenuation line arrangement (9), a magnetic field which is generated by the active current and/or a superimposed interference on the active current and/or a leakage current which is caused by the active current is attenuated by current flow induced in the attenuation line arrangement (9),
**characterised in that**
the attenuation line arrangement (9) comprises at least one attenuation line (10), wherein the at least one attenuation line (10) is arranged at least in parts parallel to the active current line (2, 16) and the inductive coupling is strengthened by at least one coupling component encompassing the active current line (2, 16) and the at least one attenuation line (10), wherein the motor vehicle (1) has a body (7) and the attenuation line (10) is connected to the body (7) at both ends (11), or wherein the motor vehicle (1) has power electronics (17), the electrical load is an electric motor (15) and the attenuation line (10) is connected to a housing (22) of the power electronics (17) and a housing (24) of the electric motor.

2. Motor vehicle (1) according to claim 1,
**characterised in that**
the attenuation line arrangement (9) comprises at least one electrical filter (20).

3. Motor vehicle (1) according to claim 1 or 2,
**characterised in that**
the coupling component is a magnetic ring (12).

4. Motor vehicle (1) according to claim 3,
**characterised in that**
the magnetic ring (12) consists of ferrite or a nanocrystalline material.

5. Motor vehicle (1) according to any one of the preceding claims,
**characterised in that**
the protection area (13) is a passenger area and/or includes the area of an electrical circuit arrangement and/or a sensor arrangement, in particular a Hall probe (14).

6. Motor vehicle (1) according to any one of the preceding claims,
**characterised in that**
the electrical load is a starter (3) or a drive motor (15) of the motor vehicle.

## Revendications

1. Véhicule automobile (1) comprenant au moins une ligne de courant utile (2, 16) pouvant être alimentée, qui transporte au moins temporairement un courant utile permettant de faire fonctionner au moins un consommateur électrique, dans lequel au moins un agencement de ligne d'affaiblissement (9) est couplé, par l'intermédiaire d'un couplage inductif, à la ligne de courant utile (2, 16) pouvant être alimentée, de telle manière que, dans une région de protection (13) se trouvant à distance de la ligne de courant utile (2, 16) et de l'agencement de ligne d'affaiblissement (9), un champ magnétique, généré par le courant utile et/ou une perturbation interférant avec le courant utile et/ou un courant de fuite provoqué par le courant utile, est affaibli grâce au flux de courant induit dans l'agencement de ligne d'affaiblissement (9),
**caractérisé en ce que**
l'agencement de ligne d'affaiblissement (9) comprend au moins une ligne d'affaiblissement (10), dans lequel la au moins une ligne d'affaiblissement (10) est agencée parallèlement à la ligne de courant utile (2, 16) au moins par sections et le couplage inductif est renforcé grâce à au moins un composant de couplage entourant la ligne de courant utile (2, 16) et la au moins une ligne d'affaiblissement (10), dans lequel le véhicule automobile (1) présente une carrosserie (7) et la ligne d'affaiblissement (10) est reliée au niveau des deux extrémités (11) à la carrosserie (7), ou dans lequel le véhicule automobile (1) présente une électronique de puissance (17), le consommateur électrique est un moteur électrique (15) et la ligne d'affaiblissement (10) est reliée à un boîtier (22) de l'électronique de puissance (17) et à un boîtier (24) du moteur électrique.

2. Véhicule automobile (1) selon la revendication 1,
**caractérisé en ce que**
l'agencement de ligne d'affaiblissement (9) comprend au moins un filtre électrique (20).

3. Véhicule automobile (1) selon la revendication 1 ou 2,
**caractérisé en ce que**
l'élément de couplage est un anneau magnétique (12).

4. Véhicule automobile (1) selon la revendication 3,
**caractérisé en ce que**
l'anneau magnétique (12) consiste en de la ferrite ou en un matériau nanocristallin.

5. Véhicule automobile (1) selon l'une quelconque des revendications précédentes,
**caractérisé en ce que**
la région de protection (13) est une région d'accueil de personnes et/ou inclut l'emprise d'un agencement de circuit électrique et/ou d'un agencement de détecteur, en particulier d'une sonde à effet Hall (14).

6. Véhicule automobile (1) selon l'une quelconque des revendications précédentes,
**caractérisé en ce que**
le consommateur électrique est un démarreur (3) ou un moteur d'entraînement (15) du véhicule automobile.
